# EUROPÄISCHE PATENTSCHRIFT

(11) **EP 3 172 749 B1**
(45) Veröffentlichungstag und Bekanntmachung des Hinweises auf die Patenterteilung: **20.01.2021**
(21) Anmeldenummer: 15750632.0
(22) Anmeldetag: 20.07.2015
(51) Int. Cl.: H01H 1/021, H01H 11/06, B29C 45/16, H05K 3/10, H05K 3/40

(54) **KUNSTSTOFF-BAUTEIL MIT ZUMINDEST EINEM ELEKTRISCHEN KONTAKTELEMENT**
PLASTIC COMPONENT HAVING AT LEAST ONE ELECTRIC CONTACT ELEMENT
COMPOSANT EN MATIÈRE PLASTIQUE POURVU D'AU MOINS UN ÉLÉMENT DE CONTACT ÉLECTRIQUE

(30) Priorität: 21.07.2014 DE 102014010628
(43) Veröffentlichungstag der Anmeldung: 31.05.2017
(73) Patentinhaber: Krallmann Kunststoffverarbeitung GmbH, 32120 Hiddenhausen (DE)
(72) Erfinder: ENGELMANN, Eduard, 32257 Bünde (DE)
(74) Vertreter: Lichti - Patentanwälte Partnerschaft mbB
(86) Internationale Anmeldenummer: PCT/EP2015/001491
(87) Internationale Veröffentlichungsnummer: WO 2016/012090

(56) Entgegenhaltungen:
- EP-A1- 1 780 541
- WO-A2-02/056653
- DE-A1- 4 432 966
- DE-A1-102009 022 238
- DE-A1-102012 212 798
- DE-B- 1 299 801
- US-A- 5 688 146

## Beschreibung

Die Erfindung betrifft ein Kunststoff-Bauteil mit zumindest einem elektrischen Kontaktelement, wobei das Kunststoff-Bauteil einen Kunststoff-Körper und zumindest eine elektrische Leiterbahn aufweist, mittels der das elektrische Kontaktelement elektrisch anschließbar ist. Ferner betrifft die Erfindung ein Verfahren zur Herstellung eines entsprechenden Kunststoff-Bauteils.

In vielen Bereichen der Technik ist es notwendig, einen Schaltvorgang auszulösen, indem zwei voneinander beabstandete elektrische Kontaktelemente relativ zueinander verstellt und miteinander in Anlage gebracht werden, wodurch ein elektrischer Stromfluss bewirkt wird, der den Schaltvorgang auslöst. Die elektrischen Kontaktelemente sind üblicherweise an einem als Träger dienenden Kunststoff-Körper angeordnet und über eine an dem Kunststoff-Körper ausgebildete Leiterbahn elektrisch angeschlossen. Zur Ausbildung einer elektrischen Leiterbahn an einem Kunststoff-Körper ist es bekannt, den Kunststoff-Körper in einem ersten Schritt durch Spritzgießen herzustellen und in einem nachgeschalteten Verfahrensschritt die Leiterbahn an dem Kunststoff-Körper auszubilden. Dies kann beispielsweise dadurch erreicht werden, dass die Leiterbahn aus einem Metallblech ausgestanzt und anschließend an dem vorgefertigten Kunststoff-Körper angebracht wird. Es ist jedoch auch möglich, die aus dem Metallblech ausgestanzte Leiterbahn nachträglich mit dem den Kunststoff-Körper bildenden Kunststoffmaterial zu umspritzen.

Darüber hinaus ist es bekannt, zunächst den Kunststoff-Körper und einen metallisierbaren Körper herzustellen und anschließend den metallisierbaren Körper beispielsweise durch einen Galvanisiervorgang zu metallisieren.

Mit den genannten Verfahren ist der Nachteil verbunden, dass sie sehr aufwändig und somit kostenintensiv sind.

Aus der DE 10 2011 101 956 A1 ist allgemein ein Verfahren zum zwei-komponentigen Spritzgießen bekannt, bei dem eine Kunststoff-Komponente mittels einer Spritzgussform hergestellt und auf die Kunststoff-Komponente eine Metall-komponente aufgespritzt wird. Hierzu wird eine spezielle Düse zum Spritzen von Metall verwendet, die unter anderem ein beheiztes Düsenrohr aufweist. Aus der EP 1 780 541 A1 ist ein Kunststoff-Bauteil gemäß dem Oberbegriff des Anspruchs 1 bekannt.

Der Erfindung liegt die Aufgabe zugrunde, ein Kunststoff-Bauteil mit zumindest einem elektrischen Kontaktelement und einer Leiterbahn zu schaffen, das sich in einfacher Weise herstellen lässt. Ferner soll ein Verfahren zur Herstellung eines entsprechenden Kunststoff-Bauteils vorgesehen werden.

Diese Aufgabe wird erfindungsgemäß durch ein_ Kunststoff-Bauteil mit den Merkmalen des Anspruchs 1 gelöst.

Hinsichtlich des Kunststoff-Bauteils ist vorgesehen, dass das Kunststoff-Bauteil mittels eines kombinierten Spritzguss- und Metallgussverfahrens hergestellt ist, bei dem der Kunststoff-Körper mittels eines Spritzgussverfahrens und bei dem mindestens eine elektrische Leiterbahn mittels eines Metallguss- oder Metallspritzverfahrens nacheinander hergestellt sind, wobei die zuletzt ausgebildete Komponente an die zuvor ausgebildete Komponente angespritzt ist. Die Herstellung des Kunststoff-Bauteils bzw. der beiden Komponenten erfolgt vorzugsweise nacheinander in einem kombinierten Spritzgusswerkzeug, mit dem sowohl ein Kunst-stoffMaterial und unabhängig davon auch ein flüssiges Metall bzw. eine Metall-Legierung verarbeitet werden können. Das metallene Material wird insbesondere mittels eines Metall-Druckguss-verfahrens oder mittels eines Metall-Spritzgussverfahrens eingebracht. Auf diese Weise ist es möglich, das Kunststoff-Bauteil zusammen mit der elektrischen Leiterbahn und dem elektrischen Kontaktelement in einem einheitlichen Verfahren sehr schnell und kosten-günstig herzustellen. Vorzugsweise wird in einem ersten Schritt der Kunststoff-Körper gefertigt, an den an-schließend die elektrische Leiterbahn angespritzt wird. Diese Reihenfolge kann jedoch auch umgekehrt werden, wenn es die Bauteilgeometrie erlaubt.

In bevorzugter Ausgestaltung der Erfindung ist vorgesehen, dass der Kunststoff-Körper eine kanalförmige Nut aufweist, in der die Leiterbahn angeordnet ist. Nachdem der Kunststoff-Körper mit der kanalförmigen Nut ausgebildet ist, kann das flüssige Metall direkt in die kanalförmige Nut eingebracht werden, wobei es durch die Nutwandungen geführt ist. Das flüssige Metall fließt die kanalförmige Nut entlang und füllt diese vollständig aus, wodurch die elektrische Leiterbahn gebildet ist. Die Einbringung des flüssigen Metalls in die kanalförmige Nut kann durch direktes Eingießen oder vorzugsweise durch direktes Ein-spritzen der Metallschmelze in die Nut erfolgen.

Um die Leiterbahn zuverlässig in der Nut zu halten, kann diese zumindest in Teilbereichen formschlüssig in der Nut bzw. an dem Kunststoff-Körper gehalten sein. Zu diesem Zweck kann vorgesehen sein, dass in oder an der Nut Hinterschneidungen ausgebildet sind, in die die Leiterbahn zumindest teilweise eingreift. Wenn das flüssige Metall in die Nut eingebracht wird, hinterströmt es die Hinterschneidungen, so dass es im verfestigten Zustand sicher und unlösbar in der Nut gehalten ist. Eine entsprechende formschlüssige Anbringung der Leiterbahn an den Kunststoff-Körper kann auch vorgesehen sein, wenn keine Nut ausgebildet ist.

Die Nut kann von einer im Kunststoff-Körper ausgebildeten Vertiefung gebildet sein, es ist jedoch auch möglich, auf dem Kunststoff-Körper vorzugsweise im Wesentlichen parallel verlaufende Rippen vorzusehen, zwischen denen die kanalförmige Nut gebildet ist. Die Rippen haben den zusätzlichen Vorteil, dass sie die Biegesteifigkeit des Kunststoff-Körpers und somit dessen Stabilität erhöhen.

Das Kunststoff-Bauteil besitzt zumindest ein elektrisches Kontaktelement, das mit einem weiteren elektrischen Kontakt, der an einem anderen Bauteil ausgebildet ist, zur Erzielung eines Schaltvorgangs in Anlage treten kann. In einfachster Ausgestaltung kann vorgesehen sein, dass das elektrische Kontaktelement von einem hervorstehenden, an oder auf der Leiterbahn ausgebildeten kuppenartigen Kontaktpunkt gebildet ist.

In der Erfindung ist vorgesehen, dass das elektrische Kontaktelement ein Federlaschen-Kontakt ist, der eine Federlasche des Kunststoff-Körpers umfasst, auf der ein Abschnitt der Leiterbahn angeordnet ist. Die Federlasche ist frei auskragend ausgebildet, d.h. sie ist nur an einer Seite mit dem Kunststoff-Körper verbunden und auf allen anderen Seiten von diesem frei bzw. von Aussparungen im Kunststoff-Körper umgeben. Dies bringt den Vorteil mit sich, dass die Federlasche relativ zu dem Kunststoff-Körper verstellt werden kann, indem sie mittels eines geeigneten Betätigungselementes aus ihrer Ausgangsstellung unter elastischer Verformung ausgelenkt wird. Sobald die entsprechende Verstellkraft auf die Federlasche einwirkt, kehrt diese aufgrund ihrer inneren Spannungen in die Ausgangslage zurück.

Die Leiterbahn verläuft dabei auf der Federlasche und erstreckt sich über den Anschlussbereich der Federlasche an dem Kunststoff-Körper bis auf dessen Oberfläche. Auf diese Weise ist erreicht, dass die Stabilität und die Elastizität des elektrischen Kontaktelementes fast ausschließlich von dem Kunststoff-Material des Kunststoff-Körpers bzw. der Federlasche gebildet ist, so dass der die elektrische Leiterbahn bildende Werkstoff nur geringe Belastungen erfährt, wodurch die Gebrauchsdauer erhöht ist.

Um einen definierten Kontaktpunkt zu haben, kann in Weiterbildung der Erfindung vorgesehen sein, dass die Federlasche im Bereich ihres freien Endes einen Vorsprung aufweist, der von der Leiterbahn überdeckt ist. Dabei kann der Vorsprung beispielsweise kuppen- oder stiftförmig ausgebildet sein. Der von der Leiterbahn überdeckte Vorsprung steht in Bewegungsrichtung der Federlasche über die Leiterbahn hervor, so dass zuverlässig erreicht ist, dass die Federlasche bei ihrer Betätigung an diesem Kontaktpunkt mit dem Gegenkontakt in Anlage kommt, so dass exakte Schaltvorgänge erreicht sind.

In einer weiteren Ausgestaltung der Erfindung kann das elektrische Kontaktelement ein Stecker sein, der eine vom Kunststoff-Körper hervorstehende Zunge umfasst, an der ein Abschnitt der Leiterbahn angeordnet ist. Die Zunge ist so dimensioniert, dass sie ihre Position relativ zu dem Kunststoff-Körper an diesem beibehält, d.h. nicht federnd ausweicht. Die Leiterbahn erstreckt sich vom Kunststoff-Körper bis auf die Oberfläche der Zunge, so dass diese als Stecker dienen kann, auf den ein Gegenstecker beispielsweise eines Kabelbaums aufgesetzt werden kann.

In einer weiteren Ausgestaltung der Erfindung kann vorgesehen sein, dass das elektrische Kontaktelement eine Kontaktbuchse ist, die ein hülsenförmiges Tragteil umfasst, wobei auf der Innenwandung des hülsenförmigen Tragteils ein Abschnitt der Leiterbahn angeordnet ist. Das hülsenförmige Tragteil ist vorzugsweise ein integraler Bestandteil des Kunststoff-Körpers und somit einstückig mit diesem verbunden und kragt von dem Kunststoff-Körper frei aus. Die Innenwandung des Innenraums des hülsenförmigen Tragteils ist zumindest teilweise und vorzugsweise vollständig mit dem elektrisch leitenden Material überzogen und in den Innenraum des Tragteils kann ein Stecker, beispielsweise ein Klinkenstecker eingesteckt werden.

Das hülsenförmige Tragteil sitzt mit einem Ende auf dem Kunststoff-Körper und kragt von diesem aus. Dabei kann vorgesehen sein, dass in dem Kunststoff-Körper im Anschlussbereich des Tragteils eine Durchbrechung ausgebildet ist, die den Innenraum des hülsenförmigen Tragteils mit der dem Tragteil abgewandten Seite des Kunststoff-Körpers verbindet, wobei die Leiterbahn sich durch die Durch-brechung hindurch erstreckt. Auf diese Weise kann die Leiterbahn auf der dem Tragteil abgewandten Seite des Kunststoff-Körpers auf diesem bis zu dem Tragteil geführt sein, durchdringt dann den Kunststoff-Körper an der Durch-brechung und geht in den auf der Innenwandung des Tragteils angeordneten Abschnitt der Leiterbahn über. Auf diese Weise ist eine einfache und gute Kontaktierung möglich.

In einer weiteren Ausgestaltung der Erfindung kann vorgesehen sein, dass in den Kunststoff-Körper zumindest eine vorgefertigte Kontaktniete integriert ist, die bei der Herstellung des Kunststoff-Körpers eingespritzt oder umspritzt werden kann. Die Kontaktniete ist mit der Leiterbahn elektrisch verbunden. Auf diese Weise kann ein Kontaktelement gebildet werden, dessen Material nicht zwangsläufig dem Material der Leiterbahn entspricht, sondern es ist möglich, das Material der Kontaktniete an die gewünschten Rahmenbedingungen anzupassen und insbe-sondere die Kontaktniete aus einem härteren Material als die Leiterbahn herzustellen.

In einer möglichen Ausgestaltung der Erfindung kann vorgesehen sein, dass der Kunststoff-Körper im Wesentlichen plattenförmig ist. Es ist jedoch auch möglich, den Kunststoff-Körper in einer anderen Konfiguration, beispielsweise als Gehäuse auszubilden.

Hinsichtlich des Verfahrens wird die obenstehende Aufgabe dadurch gelöst, dass das Kunststoff-Bauteil mittels eines kombinierten Spritzguss- und Metallgussverfahrens hergestellt wird, bei dem ein Kunststoff-Körper mittels eines Spritzgussverfahrens und mindestens eine elektrische Leiterbahn mittels eines Metallguss- oder Metallspritzverfahrens nacheinander hergestellt werden, wobei die zuletzt ausgebildete Komponente an die zuvor ausgebildete Komponente angespritzt wird.

Vorzugsweise ist vorgesehen, dass zunächst der Kunststoff-Körper hergestellt und die elektrische Leiterbahn an-schließend an diesen angespritzt wird. Alternativ ist es jedoch auch möglich, zunächst die elektrische Leiterbahn herzustellen und anschließend den Kunststoff-Körper an diese anzuspritzen.

In bevorzugter Ausgestaltung der Erfindung ist vorgesehen, dass die nachträglich ausgebildete Komponente formschlüssig an der zuvor ausgebildeten Komponente befestigt wird. Dies kann beispielsweise dadurch erreicht werden, dass in der zuvor ausgebildeten Komponente, beispielsweise dem Kunststoff-Körper, Hinterschneidungen ausgebildet sind.

Alternativ oder zusätzlich dazu kann vorgesehen sein, dass die nachträglich ausgebildete Komponente stoffschlüssig an der zuvor ausgebildeten Komponente befestigt wird. Zu diesem Zweck können die Materialeigenschaften und die Verfahrensparameter so aufeinander abgestimmt sein, dass die beiden Komponenten miteinander verschweißen, d.h. eine molekulare Bindung eingehen. Alternativ oder zusätzlich dazu kann zwischen den beiden Komponenten zumindest eine Oberflächenhaftung vorgesehen sein, was beispielsweise dadurch erreicht werden kann, dass es beim Anspritzen der nachträglich ausgebildeten Komponente zu einem ober-flächlichen Anschmelzen des Materials der zuvor ausge-bildeten Komponente kommt.

Als Material für den Kunststoff-Körper kann jeder spritzfähige Kunststoff, beispielsweise Polypropylen oder Polyamid verwendet werden. Als Metall-Komponente kann eine Metall-Legierung verwendet werden, die bis zu einer Temperatur von 500°C fließfähig ist und wobei es sich beispielsweise um Sn-Legierungen handeln kann.

Weitere Einzelheiten und Merkmale der Erfindung sind aus der folgenden Beschreibung von Ausführungsbeispielen unter Bezugnahme auf die Zeichnung ersichtlich. Es zeigen:
- Fig. 1: eine Aufsicht auf einen Kunststoff-Körper vor Aufbringung der Leiterbahn,
- Fig. 2: den Kunststoff-Körper gemäß Fig. 1 nach Auf-bringung der Leiterbahn,
- Fig. 3: eine vergrößerte Aufsicht auf ein elektri-sches Kontaktelement in Form einer Federlasche,
- Fig. 4: den Schnitt IV-IV in Fig. 3,
- Fig. 5: den Schnitt V-V in Fig. 3,
- Fig. 6: eine vergrößerte Aufsicht auf ein elektrisches Kontaktelement in Form eines Steckers,
- Fig. 7: den Schnitt VII-VII in Fig. 6,
- Fig. 8: den Schnitt VIII-VIII in Fig. 6,
- Fig. 9: eine vergrößerte Aufsicht auf ein elektrisches Kontaktelement in Form einer Kontaktbuchse,
- Fig. 10: den Schnitt X-X in Fig. 9,
- Fig. 11: eine erste Abwandlung einer Hinterschneidung,
- Fig. 12: den Schnitt XII-XII in Fig. 11,
- Fig. 13: eine zweite Abwandlung einer Hinterschneidung,
- Fig. 14: den Schnitt XIV-XIV in Fig. 13,
- Fig. 15: eine dritte Abwandlung einer Hinterschneidung und
- Fig. 16: den Schnitt XVI-XVI in Fig. 15.

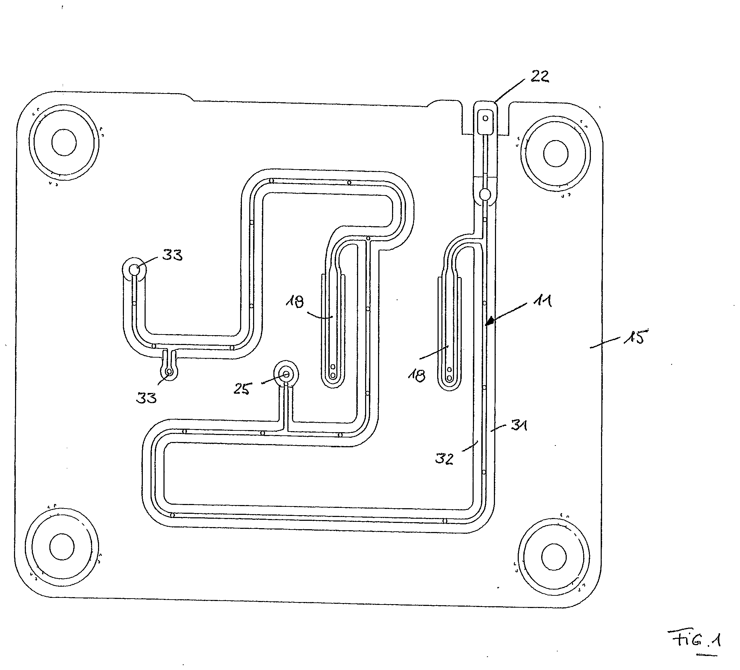

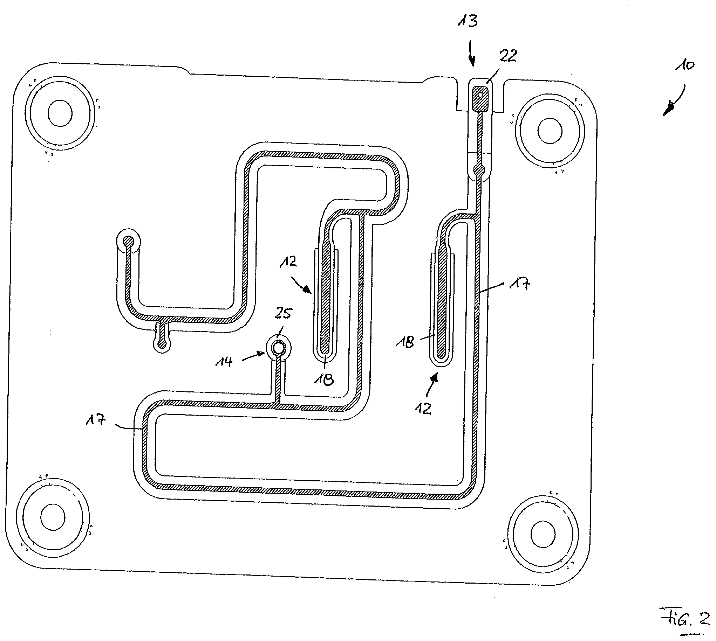

Fig. 1 zeigt eine Aufsicht auf einen plattenförmigen Kunststoff-Körper 15, der in einem ersten Verfahrensschritt aus einem Kunststoff-Material gespritzt ist und in einem nachfolgenden Verfahrensschritt mit einer Leiterbahn 17 (siehe Fig. 2) versehen wird, die durch Anspritzen eines elektrisch leitenden Werkstoffs, insbesondere einer Metall-Legierung ausgebildet wird, so dass ein Kunststoff-Bauteil 10 gebildet ist.

In dem Kunststoff-Körper 15 ist eine kontinuierliche kanalförmige Nut 11 ausgebildet, die von parallel verlaufenden Rippen 31 und 32 begrenzt ist. Zur Vorbereitung der Ausbildung von elektrischen Kontaktelementen sind an dem Kunststoff-Körper eine seitlich hervorstehende Zunge 22, mehrere frei auskragend ausgebildete Federlaschen 18, ein hülsenförmiges Tragteil 25 und mehrere Kontaktkörper 33 ausgebildet. Alle genannten Elemente sind mittels der kanalförmigen Nut 11 miteinander verbunden.

In die Nut 11 wird in einem zweiten Verfahrensschritt ein elektrisch leitendes Material, insbesondere eine Metall-Legierung eingegossen oder eingespritzt, so dass die Nut 11 vollständig ausgefüllt ist und alle genannten Bauteile elektrisch miteinander unter Bildung der kontinuierlichen Leiterbahn 17 verbunden sind.

Der konstruktive Aufbau der einzelnen elektrischen Kontaktelemente wird im folgenden näher erläutert.

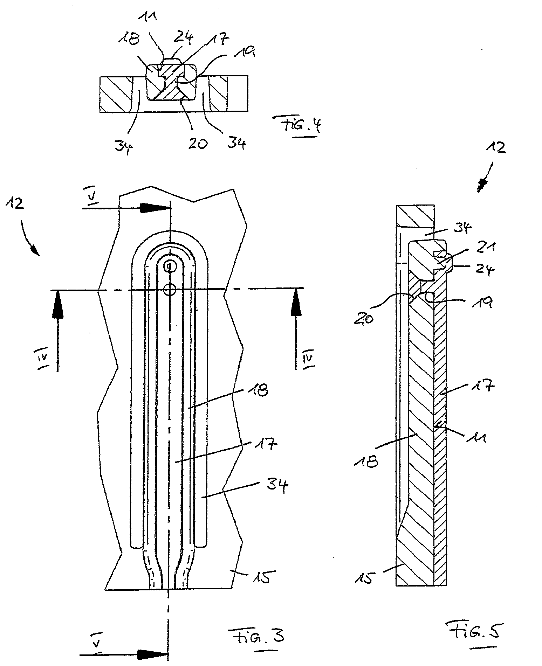

Die Fig. 3 bis 5 zeigen ein elektrisches Kontaktelement in Form eines Federlaschenkontaktes 12. Der Federlaschenkontakt 12 weist eine Federlasche 18 auf, die frei auskragend an dem Kunststoff-Körper 15 und einstückig mit diesem ausgebildet ist. Die Federlasche 18 besitzt eine langgestreckte Form und ist an ihrem schmalen Ende an dem Kunststoff-Körper 15 angeschlossen und kragt von diesem Anschlussbereich frei aus, d.h. auf allen anderen Seiten ist die Federlasche 18 von einer den Kunststoffkörper 15 durchdringenden Ausnehmung 34 umgeben.

Auf der Oberseite der Federlasche 18 ist ein Abschnitt der kanalförmigen Nut 11 ausgebildet, der über den Anschlussbereich der Federlasche 18 verläuft. Die Nut 21 ist mit einem elektrisch leitenden Material gefüllt, so dass die Leiterbahn 17 gebildet ist. Im Bereich des vorderen, dem Anschlussbereich abgewandten Ende der Federlasche 18 ist eine Durchbrechung 19 ausgebildet, die sich im Querschnitt auf der der Leiterbahn 17 abgewandten Seite erweitert, so dass eine Hinterschneidung 20 gebildet ist, die mit dem elektrisch leitenden Material gefüllt ist, so dass die Leiterbahn 17 formschlüssig gehalten ist.

Am vorderen, den Anschlussbereich abgewandten freien Ende der Federlasche 18 ist ein kuppen- oder stiftförmiger Vorsprung 21 ausgebildet, der von der Leiterbahn 17 überdeckt ist, so dass ein von der Oberfläche der Leiterbahn 17 hervorstehender Kontaktpunkt 24 gebildet ist.

Die Federlasche 18 ist aufgrund ihrer Geometrie senkrecht zur Plattenebene des Kunststoff-Körpers 15 elastisch verformbar, so dass ein verstellbares Schaltelement ge-bildet ist, wobei die Verformungs- und Rückstell-eigenschaften durch die Geometrie der Federlasche 18 und deren Material bestimmt ist, während die Leiterbahn 17 lediglich dem elektrischen Anschluss dient und somit nur geringen mechanischen Belastungen unterliegt.

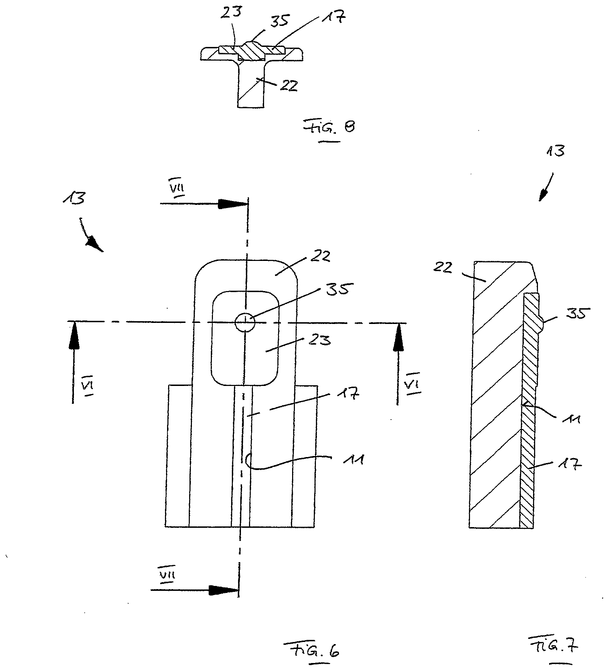

Die Fig. 6 bis 8 zeigen eine Ausgestaltung eines elektrischen Kontaktelementes in Form eines Steckers 13. Der Stecker 13 besitzt eine vom Kunststoff-Körper 15 hervorstehende eigenstabile Zunge 22, die integraler Be-standteil des Kunststoff-Körpers 15 ist und auf ihrer Oberseite einen Abschnitt der kanalförmigen Nut 11 auf-weist. In dem vom Kunststoff-Körper 15 hervorstehenden Bereich der Zunge 22 ist die Nut 11 in ihrem Querschnitt verbreitert, so dass das in die Nut 11 eingebrachte elektrisch leitende Material in diesem Bereich eine Kontaktplatte 23 mit vergrößerten Abmessungen bildet, wodurch die Zuverlässigkeit des elektrischen Kontaktes erhöht ist. Ferner ist auf der Oberfläche der Leiterbahn 17 im Bereich der Kontaktplatte 23 ein kuppenförmiger Vor-sprung 35 ausgebildet, der einen definierten Kontaktpunkt bildet.

Auf den in den Fig. 6 bis 8 dargestellten Stecker kann beispielsweise ein Gegenstecker eines Kabelbaums aufge-steckt werden, um einen elektrischen Kontakt herzustellen. Der kuppenförmige Vorsprung 35 kann dabei auch als Rast-element zur Sicherung der Steckverbindung dienen.

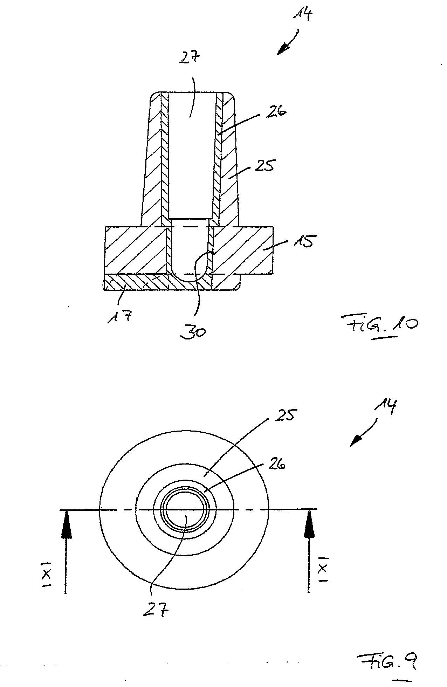

Die Fig. 9 und 10 zeigen ein elektrisches Kontaktelement in Form einer Kontaktbuchse 14, in die ein Stecker, beispielsweise ein Klinkenstecker eingeführt werden kann. Die Kontaktbuchse 14 besitzt ein hülsenförmiges Tragteil 25, das an dem Kunststoff-Körper angeformt und einstückig mit diesem ausgebildet ist und von dem Kunststoff-Körper 15 frei auskragend nach oben hervorsteht. Auf der dem hülsenförmigen Tragteil 25 abgewandten Seite des Kunststoff-Körpers ist die Nut 11 ausgebildet, die über eine im Kunststoff-Körper 15 vorgesehene Durchbrechung 30 mit dem Innenraum 27 des hülsenförmigen Tragteils 25 verbunden ist. Die Leiterbahn 17 erstreckt sich in der Nut 11 des Kunststoff-Körpers 15, durchgreift diesen an der Durchbrechung 30 und ist als Beschichtung 26 auf der Innenwandung des hülsenförmigen Tragteils 25 vorgesehen. Auf diese Weise steht ein Stecker, der in den Innenraum 27 des Tragteils 25 eingesetzt wird, über die Beschichtung 26 durch die Durch-brechung 30 hindurch mit der in der Nut 11 befindlichen Leiterbahn 17 in Verbindung.

Um eine sichere Halterung der Leiterbahn 17 in der Nut zu gewährleisten, sollten diese beiden Elemente formschlüssig in Eingriff stehen. Mögliche Ausgestaltungen der Querschnittsgeometrien zur Erzielung eines entsprechenden Formschlusses sind in den folgenden Figuren dargestellt.

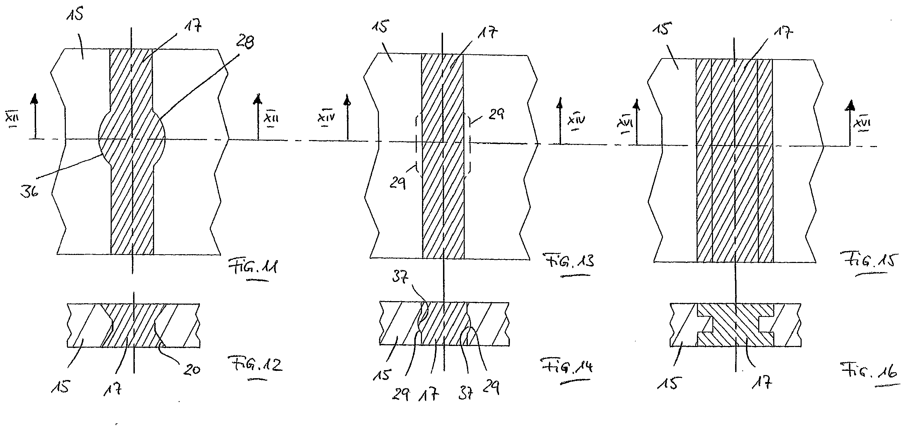

Gemäß Fig. 11 besitzt die kanalförmige Nut 11 eine lokale Querschnittserweiterung 36, so dass eine Hinterschneidung 28 gebildet ist, die eine Sicherung in Längsrichtung der Nut 11 bewirkt. Zusätzlich dazu kann gemäß Fig. 12 vorgesehen sein, dass die Nut 11 zumindest im Bereich der Querschnittserweiterung 36 einen sich über die Höhe in der Weite ändernden Querschnitt besitzt, wobei im dargestellten Ausführungsbeispiel ein hyperboloid-artiger Querschnitt vorgesehen ist, der sowohl auf der Oberseite als auch der Unterseite eine Hinterschneidung 20 bildet.

Eine weitere Möglichkeit des Formschlusses ist in den Fig. 13 und 14 dargestellt. Dabei besitzt die kanalförmige Nut 11 in einem lokal begrenzten Bereich eine Querschnittserweiterung 29 im Bereich des mittleren Abschnitts ihrer Höhe, so dass die Leiterbahn 17 seitlich hervorstehende Vorsprünge 37 aufweist die mit dem umgebenden Kunststoff-Körper 15 in Eingriff stehen.

Eine gleichartige formschlüssige Wirkung wird mit der Ausgestaltung gemäß den Fig. 15 und 16 erreicht, wobei der die kanalförmige Nut 11 einen I-förmigen Querschnitt be-sitzt, der vollständig mit dem elektrisch leitenden Material der Leiterbahn 17 befüllt ist. Auf diese Weise ist die Leiterbahn an einem Lösen bzw. Abheben aus der Nut 11 zuverlässig gesichert.

## Patentansprüche

1. Kunststoff-Bauteil (10) mit zumindest einem elektrischen Kontaktelement (12, 13, 14, 16), wobei das Kunststoff-Bauteil (10) einen Kunststoff-Körper (15) und zumindest eine elektrische Leiterbahn (17) auf-weist, mittels der das elektrische Kontaktelement (12, 13, 14, 16) elektrisch anschließbar ist, wobei das Kunststoff-Bauteil (10) mittels eines kombinierten Spritzguss- und Metallgussverfahrens hergestellt ist, bei dem der Kunststoff-Körper (15) mittels eines Spritzgussverfahrens und die zumindest eine elektrische Leiterbahn (17) mittels eines Metallguss- oder Metallspritzverfahrens nacheinander hergestellt sind, wobei die zuletzt ausgebildete Komponente an die zuvor ausgebildete Komponente angespritzt ist, wobei das elektrische Kontaktelement ein Federlaschen-Kontakt (12) ist, der eine Federlasche (18) des Kunststoff-Körpers (15) umfasst, an der ein Abschnitt der Leiterbahn (17) angeordnet ist, wobei die Federlasche (18) frei auskragend ausgebildet ist und nur an einer Seite mit dem Kunststoff-Körper (15) verbunden ist, **dadurch gekennzeichnet, dass** die Federlasche (18) auf allen anderen Seiten von einer Aussparung (34) im Kunststoff-Körper (15) umgeben ist.

2. Kunststoff-Bauteil nach Anspruch 1, **dadurch gekennzeichnet, dass** die Federlasche (18) im Bereich ihres freien Endes einen Vorsprung (21) aufweist, der von der Leiterbahn (17) überdeckt ist

3. Kunststoff-Bauteil nach Anspruch 2, **dadurch gekennzeichnet, dass** der Vorsprung (21) kuppen- oder stiftförmig ausgebildet ist.

4. Kunststoff-Bauteil nach einem der Ansprüche 1 bis 3, **dadurch gekennzeichnet, dass** der Kunststoff-Körper (15) eine kanalförmige Nut (11) aufweist, in der die Leiterbahn (17) angeordnet ist.

5. Kunststoff-Bauteil nach Anspruch 4, **dadurch gekennzeichnet, dass** die Leiterbahn (17) in der Nut (11) zumindest in Teilbereichen formschlüssig gehalten ist.

6. Kunststoff-Bauteil nach Anspruch 5, **dadurch gekennzeichnet, dass** in oder an der Nut (11) Hinterschneidungen (20, 28, 29) ausgebildet sind, in die die Leiterbahn (17) zumindest teilweise eingreift.

7. Kunststoff-Bauteil nach einem der Ansprüche 1 bis 6, **dadurch gekennzeichnet, dass** in den Kunststoff-Körper (15) zumindest eine Kontaktniete integriert ist, die mit der Leiterbahn (17) elektrisch verbunden ist.

8. Kunststoff-Bauteil nach einem der Ansprüche 1 bis 7, **dadurch gekennzeichnet, dass** der Kunststoff-Körper (15) plattenförmig ausgebildet ist.

## Claims

1. Plastic component (10) with at least one electrical contact element (12, 13, 14, 16), wherein the plastic component (10) has a plastic body (15) and at least one electrical strip conductor (17), by means of which the electrical contact element (12, 13, 14, 16) can be electrically connected, wherein the plastic component (10) is manufactured according to a combined injection molding and metal casting method, in which the plastic body (15) is manufactured by means of an injection molding method and the least one electrical strip conductor (17) is manufactured by means of a metal casting or metal injection molding method one after another, wherein the component formed last is molded onto the component formed first, wherein the electrical contact element is a spring bracket contact (12), which encloses a spring bracket (18) of the plastic body (15), at which a section of the strip conductor (17) is arranged, wherein the spring bracket (18) has a freely projecting configuration and is connected to the plastic body (15) only on one side, **characterized in that** the spring bracket (18) is surrounded by a recess (34) in the plastic body (15) on all other sides.

2. Plastic component in accordance with claim 1, **characterized in that** in the area of its free end, the spring bracket (18) has a projection (21), which is covered by the strip conductor (17).

3. Plastic component in accordance with claim 2, **characterized in that** the projection (21) has a tip- or pin-like configuration.

4. Plastic component in accordance with one of the claims 1 to 3, **characterized in that** the plastic body (15) has a channel-like groove (11), in which the strip conductor (17) is arranged.

5. Plastic component in accordance with claim 4, **characterized in that** the strip conductor (17) is held in the groove (11) in a positive-locking manner at least in some areas.

6. Plastic component in accordance with claim 5, **characterized in that** undercuts (20, 28, 29), with which the strip conductor (17) meshes at least partially, are formed in or at the groove (11).

7. Plastic component in accordance with one of the claims 1 through 6, **characterized in that** at least one contact rivet, which is electrically connected to the strip conductor (17), is integrated in the plastic body (15).

8. Plastic component in accordance with one of the claims 1 through 7, **characterized in that** the plastic body (15) has a plate-shaped configuration.

## Revendications

1. Composant en matière plastique (10) doté d'au moins un élément de contact électrique (12, 13, 14, 16), le composant en matière plastique (10) comportant un corps en matière plastique (15) et au moins une piste conductrice électrique (17) à l'aide de laquelle l'élément de contact électrique (12, 13, 14, 16) peut être raccordé électriquement, le composant en matière plastique (10) étant fabriqué à l'aide d'un procédé de coulage et de moulage par injection combiné dans lequel, à la suite l'un de l'autre, le corps en matière plastique (15) est fabriqué à l'aide d'un procédé de moulage par injection et l'au moins une piste conductrice électrique (17) est fabriquée à l'aide d'un procédé d'injection de métal ou de coulage de métal, le composant réalisé en dernier étant injecté au niveau du composant précédemment réalisé, l'élément de contact électrique étant un contact de bride à ressort (12) comprenant une bride à ressort (18) du corps en matière plastique (15) au niveau duquel une section de la piste conductrice (17) est disposée, la bride à ressort (18) étant réalisée de façon à saillir librement vers l'extérieur et étant reliée uniquement au corps en matière plastique (15) au niveau d'un côté, **caractérisé en ce que** la bride à ressort (18) est entourée sur tous les autres côtés par un évidement (34) pratiqué dans le corps en matière plastique (15).

2. Composant en matière plastique selon la revendication 1, **caractérisé en ce que** la bride à ressort (18) comporte une saillie (21) recouverte par la piste conductrice (17) dans la région de son extrémité libre.

3. Composant en matière plastique selon la revendication 2, **caractérisé en ce que** la saillie (21) est réalisée en forme de dôme ou de tige.

4. Composant en matière plastique selon l'une quelconque des revendications 1 à 3, **caractérisé en ce que** le corps en matière plastique (15) comporte une rainure en forme de canal (11) dans laquelle la piste conductrice (17) est disposée.

5. Composant en matière plastique selon la revendication 4, **caractérisé en ce que** la piste conductrice (17) est maintenue par complémentarité de formes dans la rainure (11), au moins dans des régions partielles de celle-ci.

6. Composant en matière plastique selon la revendication 5, **caractérisé en ce que** des détourés arrière (20, 28, 29) dans lesquels la piste conductrice (17) s'emboîte au moins en partie sont réalisés dans ou contre la rainure (11).

7. Composant en matière plastique selon l'une quelconque des revendications 1 à 6, **caractérisé en ce qu'**au moins un rivet de contact est intégré dans le corps en matière plastique (15), ledit rivet étant relié électriquement à la piste conductrice (17).

8. Composant en matière plastique selon l'une quelconque des revendications 1 à 7, **caractérisé en ce que** le corps en matière plastique (15) est réalisé en forme de plaque.
